# EUROPEAN PATENT APPLICATION

(11) **EP 4 712 081 A1**
(43) Date of publication of application: **18.03.2026**
(21) Application number: 24803340.9
(22) Date of filing: 16.04.2024
(51) Int. Cl.: G11C 16/34, G11C 11/56, G11C 16/26

(54) **INFORMATION PROCESSING DEVICE AND MEMORY MANAGEMENT METHOD**

(30) Priority: 08.05.2023 JP 2023076594
(71) Applicant: Sony Interactive Entertainment Inc., Tokyo 108-0075 (JP)
(72) Inventor: SAITO, Hideyuki, Tokyo 108-0075 (JP)
(74) Representative: Fish & Richardson P.C.
(86) International application number: PCT/JP2024/015140
(87) International publication number: WO 2024/232225

(57) **Abstract**

A flash controller of an information processing device regularly implements data read for each of block groups corresponding to ellipses 150, 152, and 154 across channels ch0 to ch3 of a flash memory. Read is tried at varied read voltages until data with an error rate which is equal to or lower than a threshold can be read, and a read voltage that is obtained in the end is stored in the memory. At the time of normal data read, data is read by using a read voltage associated with a target block.

## Description

### [Technical Field]

The present invention relates to an information processing device that accesses a flash memory and a memory management method.

### [Background Art]

With the increase in the capacity of NAND flash memories, SSDs (Solid State Drives) have come to be used as storage devices in place of conventional HDDs (Hard Disk Drives). Compared to HDDs, SSDs offer the advantage of making it possible to perform data access at a high speed and with low power consumption; on the other hand, SSDs exhibit the characteristics of low durability against repeated data read and rewrite. Because of this, in data rewrite on an SSD, a process of dispersing rewrite-target areas is performed. For example, when a rewrite request is made from a host CPU (Central Processing Unit), rewrite targets are dispersed to a plurality of memory cells as much as possible by replacing designated logical block addresses with different physical addresses (see PTL 1, for example).

### [Citation List]

### [Patent Literature]

[PTL 1] WO 2014/132346A1

### [Summary]

### [Technical Problem]

Data write into a flash memory is performed by accumulating an electric charge according to a write value in the floating gate of each memory cell. At the time of data read, a value is identified on the basis of the magnitude relation between a threshold voltage corresponding to the accumulated electric charge and a read voltage to be applied to the control gate. Because of this, if the threshold voltage is different or varies from the initial target value due to various factors such as leakage of the accumulated electric charge, it becomes difficult to perform data read at the set read voltage. If read is tried multiple times at adjusted read voltages, latency corresponding to the number of times of tries occurs, and the throughput of information processing can also be affected. This problem has become more severe due to the miniaturization and multilevel value implementation of flash memories.

The present invention has been made in view of such a problem, and an object thereof is to provide a technology that makes it possible to reduce data read latency and stably perform information processing using an SSD.

### [Solution to Problem]

An aspect of the present invention relates to an information processing device. The information processing device includes one or more processors having hardware, in which the one or more processors perform data read from a memory at predetermined intervals, determine and record a read voltage on the basis of a result of the data read, and read data to be used for information processing, at the recorded read voltage.

Another aspect of the present invention also relates to an information processing device. The information processing device includes one or more processors having hardware and a flash memory that stores data to be used by the one or more processors, in which the one or more processors perform data read from the flash memory at predetermined intervals, determine and record a read voltage on the basis of a result of the data read, and read data to be used for information processing, at the recorded read voltage.

Still another aspect of the present invention relates to a memory management method. The memory management method includes performing data read from a memory at predetermined intervals, determining and recording a read voltage on the basis of a result of the data read, and reading data to be used for information processing, at the recorded read voltage.

Note that any combination of constituent elements above, and ones that are obtained by conversion of expressions of the present invention between a method, a device, a system, a computer program, a recording medium having recorded thereon a computer program, and the like are also valid as aspects of the present invention.

### [Advantageous Effects of Invention]

The present invention makes it possible to reduce data read latency and stably perform information processing using an SSD.

### [Brief Description of Drawings]

[FIG. 1] FIG. 1 is a diagram depicting the circuitry configuration of an information processing device in an embodiment.
[FIG. 2] FIG. 2 is a diagram for explaining the relation between a threshold voltage and a read voltage.
[FIG. 3] FIG. 3 is a diagram illustrating an example of a result obtained by trying data read at varied read voltages.
[FIG. 4] FIG. 4 is a diagram depicting the configuration of functional blocks of the information processing device in the present embodiment.
[FIG. 5] FIG. 5 is a diagram depicting a configuration example of queues in the present embodiment.
[FIG. 6] FIG. 6 is a diagram depicting a setting example of types of queue processed during each phase in the present embodiment.
[FIG. 7] FIG. 7 is a diagram illustrating an example of a procedure performed by a command processing section to process commands stored in each queue while transitioning between phases in the present embodiment.
[FIG. 8] FIG. 8 is a diagram illustrating an example of the state of progress of a data read process during a period in which scan read is being implemented and the other period in the present embodiment.
[FIG. 9] FIG. 9 is a diagram illustrating an example of the data structure of a block management table to be referred to by a flash controller in the present embodiment.
[FIG. 10] FIG. 10 is a flowchart depicting a processing procedure performed by the flash controller to perform scan read and determine an optimum read voltage in the present embodiment.

### [Description of Embodiment]

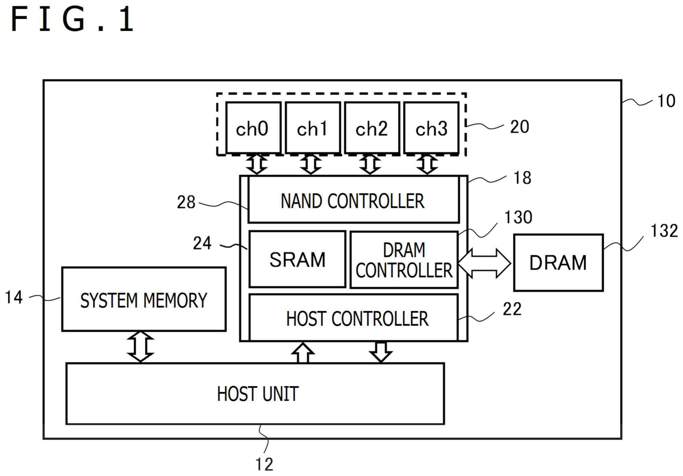

FIG. 1 depicts the circuitry configuration of an information processing device of the present embodiment. The information processing device illustrated as an example here may be any type of typical information equipment such as a mobile game console, a personal computer, a portable phone, a tablet terminal, or a PDA (Personal Digital Assistant). An information processing device 10 includes a host unit 12 including a CPU, a system memory 14, a NAND flash memory 20 (hereinafter, called the "flash memory 20" simply), a flash controller 18, and a DRAM (Dynamic Random Access Memory) 132.

The host unit 12 loads a program or data stored in the flash memory 20, onto the system memory 14, and performs information processing by using the loaded program or data. In addition, the host unit 12 reads an application program or data from a recording medium driven at an undepicted recording medium drive section, or downloads an application program or data from a server connected to a network by a communicating section and stores it in the flash memory 20. At this time, the host unit 12 issues, to the flash controller 18, an access request for accessing the flash memory 20, and the flash controller 18 implements a read/write process on the flash memory 20 in response to the access request.

The flash memory 20 is connected to a plurality of NAND flash memories, and as depicted in FIG. 1, data is dispersed and stored across a plurality of channels (four channels "ch0" to "ch3" in FIG. 1). The flash controller 18 includes a host controller 22 having a function of interfacing with the host unit 12, a NAND controller 28 having a function of interfacing with the flash memory 20, a DRAM controller 130 having a function of interfacing with the DRAM 132, and a SRAM (Static Random Access Memory) 24.

The host unit 12 generates an access request for accessing the flash memory 20, according to the progress of information processing, and stores the access request in the system memory 14. The access request includes an access-destination logical address (LBA: Logical Block Address). The host controller 22 of the flash controller 18 reads the access request stored in the system memory 14 and translates the LBA into a physical address in the flash memory 20. An address translation table required at this time is loaded onto the DRAM 132 by the DRAM controller 130 using at least part of an address translation table having originally been stored in the flash memory 20. Note that the part of the address translation table may instead be stored in the SRAM 24.

The host controller 22 supplies, to the NAND controller 28, the physical address acquired on the basis of the LBA by referring to the address translation table. The NAND controller 28 reads or writes data by accessing the relevant area in the flash memory 20 on the basis of the physical address. At this time, the NAND controller 28 reads, from the system memory 14, data stored by the host unit 12 and then writes the data in the flash memory 20. The NAND controller 28 also stores, in the system memory 14, data read from the flash memory 20, allowing the host unit 12 to read the data.

Data write into the flash memory 20 is performed by applying a voltage to the control gate of a memory cell and accumulating, in the floating gate, an electric charge according to the value of data. By controlling a threshold voltage with the use of the accumulated electric charge, a current that flows when a predetermined read voltage is applied to the control gate is used to identify a written value.

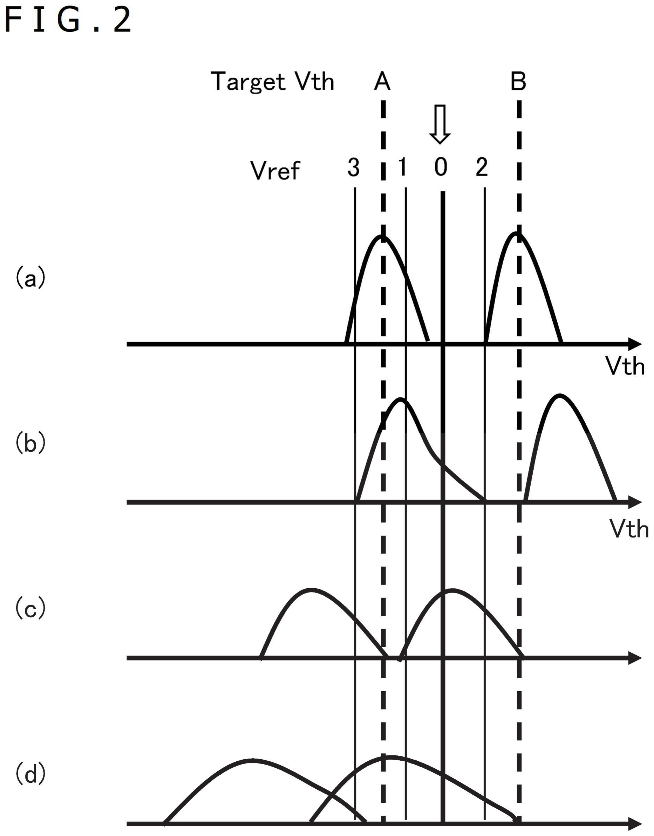

FIG. 2 is a diagram for explaining the relation between a threshold voltage and a read voltage. Each of (a) to (d) depicts the frequency distribution of a threshold voltage Vth of a memory cell group. It is assumed here that write/read of binary data is performed. However, the present embodiment is not limited to this. Assuming that target values of the threshold voltage Vth corresponding to binary values are A and B, since the actual threshold voltage varies a little among cells, its distribution exhibits a shape having certain widths centered around the target values A and B as depicted in FIG. 2.

In view of this, typically, as represented by an arrow in (a), the midpoint between the threshold-voltage target values A and B is set as a read voltage Vref. In FIG. 2, the read voltage is labeled with an identification number "0." Accordingly, the threshold voltage of all cells whose threshold-voltage target value is A becomes lower than the read voltage, resulting in a greater current value between the source and the drain. The threshold voltage of all cells whose threshold-voltage target value is B becomes higher than the read voltage, resulting in a smaller current value between the source and the drain. Thus, the two values can be distinguished correctly.

(b) depicts an example of variation of the threshold voltage in a case where the temperature at the time of data write differs from the temperature at the time of data read or in a case where read has been repeated. At the time of low temperature, a memory cell has to accumulate more electric charge than at the time of high temperature to achieve the same potential. Accordingly, a memory cell into which data has been written at the time of low temperature has accumulated more electric charge than usual. In a case where the temperature has risen thereafter, the electric charge having been accumulated more than usual causes the threshold voltage to rise.

In addition, when a read voltage is applied to the control gate at the time of data read, a small amount of electric charge is injected into the floating gate. As a result of repetition of this, the accumulated electric charge increases, and the threshold voltage rises. This affects not only the read-target memory cell, but also other pages or adjacent blocks that share word lines and bit lines with the read-target memory cell. This phenomenon is generally called read disturb. Due to temperature variation from the time of write or due to read disturb, the threshold voltage rises as a whole as depicted in (b).

(c) and (d) depict examples of variation of the threshold voltage caused by leakage of the accumulated electric charge. The electric charge accumulated in the floating gate gradually leaks over time due to stress on the tunnel oxide film or the like. In this case, as in (c) and (d), the threshold voltage lowers as a whole, and variations among memory cells also increase.

When the threshold voltage of memory cells varies as in (b) to (d), data which has been read by using the read voltage with the identification number "0" tends to include a greater amount of errors. In view of this, it is conceivable to use a plurality of voltage value candidates prepared in advance, to try read until the error rate falls within the range of ECC (Error Correction Code) correction capability. For example, as depicted in FIG. 2, in addition to the read voltage with the identification number "0," the three read voltage values with the identification numbers "1," "2," and "3" are prepared as candidates in advance.

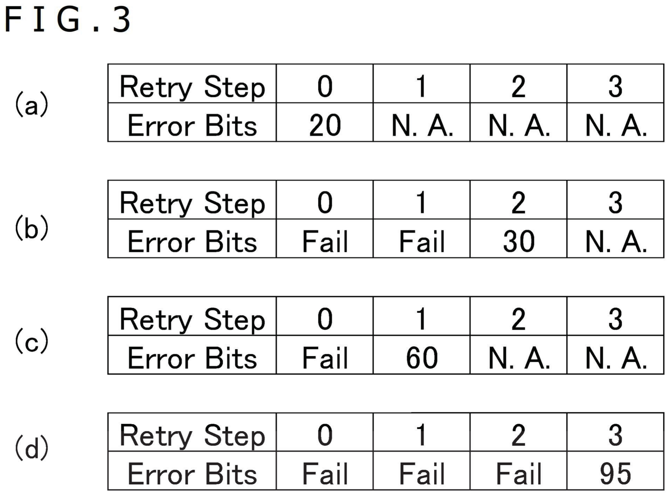

FIG. 3 illustrates an example of a result obtained by trying data read at varied read voltages. Each of (a) to (d) depicts the number of times of read retries (Retry Step) on a memory cell group having the threshold voltage distributions depicted in (a) to (d) of FIG. 2 and the number of error bits (Error Bits) in data read in each retry. It is assumed that the read voltage in each read process is varied in the order of the read voltage identification numbers depicted in FIG. 2.

In the case of (a), since the read voltage with the identification number "0" is between two distributions corresponding to the threshold-voltage target values A and B, with the number of times of retries of 0, that is, in the first read, data is read with 20 bit errors, which remain within the range of ECC correction capability. Since no retry is required in this case, "N.A." (Not Available) is displayed for the first and subsequent retries in FIG. 2.

In the case of (b), part of the distribution corresponding to the threshold-voltage target value A extends beyond the read voltage with the identification number "0." Because of this, the first read results in an error rate exceeding the ECC tolerance amount, which means read failure (displayed as "Fail"). Then, the read voltage with the identification number "1" is set, and the first retry is performed. However, also in this case, the read fails since part of the threshold voltage distribution extends beyond the read voltage. Next, the read voltage with the identification number "2" is set, and as a result of the second retry, data is read with 30 bit errors, which remain within the range of ECC correction capability.

In the case of (c), part of the distribution corresponding to the threshold-voltage target value B extends beyond the read voltage with the identification number "0." Because of this, the first read results in an error rate exceeding the ECC tolerance amount, which means read failure. Then, the read voltage with the identification number "1" is set, and as a result of the first retry, data is read with 60 bit errors, which remain within the range of ECC correction capability. Also in the case of (d), read fails with the read voltage with the identification number "0." In this case, read fails also in the first and second retries using the read voltages with the identification numbers "1" and "2." In the third retry in which the read voltage with the identification number "3" is set, data is read with 95 bit errors, which remain within the range of ECC correction capability.

In this manner, whether or not it is required to perform retries in data read and the number of times of required retries vary depending on various factors such as the temperature during data write, the elapsed time since write, and the number of times of read performed until then. Because of this, unexpected read retries are required, and irregular latency occurs before data is read. As a result, the throughput of information processing using the data lowers, the stability is impaired, and so on. This problem becomes more severe in a case where data read is concentrated in the same block.

In view of this, in the present embodiment, a process of optimizing the read voltage is regularly implemented by reading, from each block, several pages of data written in the flash memory 20 and measuring the error rate. Therefore, at the time of read of data to be used for information processing or the like, the appropriate read voltage can be set from the beginning, and it becomes unnecessary to retry read for a long time. Hereinafter, a read process for optimizing the read voltage is called "scan read." Scan read is executed by the NAND controller 28 in the background, together with other management processes related to the flash memory 20. Hereinbelow, an example of management processes performed by the NAND controller 28 is illustrated.

Typically, data read from and write into the flash memory 20 are performed in access units of 4096 bytes, for example. Since data overwrite cannot be performed in a case where a NAND flash memory is used, it is necessary to secure an unwritten area when data is to be written. As mentioned above, if data updates are repeated by changing only the logical address to disperse write areas, areas storing invalidated original data gradually increase, and areas where data can newly be written are depleted.

Since data erasure is performed in block units of several MiB (1 MiB = 10²⁰ bytes), in order to secure an unwritten area, valid data stored in an erasure-target block is copied to another block, and then, the entire data in the original block is erased. Such a process is generally called "garbage collection." That is, the NAND controller 28 needs to implement garbage collection at a timing when writable areas in the flash memory 20 are depleted or at an earlier appropriate timing.

In addition, since voltage is applied also to areas other than the target data area at the time of a read operation as mentioned above, repeated read to the same block causes read disturb, in which the data error rate increases over the entire block. Accordingly, when the number of times of read to the same block has reached a predetermined value, the NAND controller 28 needs to evacuate data in the entire block to another block.

Further, the NAND flash memory includes TLCs (Triple Level Cells) that record 3-bit data per memory cell by dividing an accumulated electric charge into eight levels. However, since TLCs require a more complex write sequence than SLCs (Single Level Cells) that record 1-bit data per memory cell by using an electric charge divided into two levels, TLCs require more time for write processes. In view of this, part of the flash memory 20 is secured in advance as an SLC area and is used as a cache to accelerate write processes. At this time, the NAND controller 28 copies data written in an SLC to a TLC at an appropriate timing separate from the execution of a write request.

In this manner, the NAND controller 28 needs to implement management processes unique to NAND flash memories separately from requests from the host unit 12. Once a management process becomes necessary, normal data read and write processes are forced to wait for a relatively long period until the management process is completed. As a result, in some cases, non-negligible latency occurs in information processing, the throughput of the overall process lowers significantly, and so on. In a mode in which data stored in the flash memory 20 is read frequently and display images are rendered, the frequency of management processes also increases along with the increase of the number of times of access, making the problem more likely to surface, combined with stringent time-related limitations until image display.

In view of this, in the present embodiment, it is made possible to minimize latency of information processing while maintaining an appropriate balance between the implementation frequency of data read and write processes required for the information processing and the implementation frequency of management processes including scan read, and implementing both types of process without disruption. Specifically, management processes like the ones mentioned above and access requests from the host unit 12 are classified on the basis of their processing contents and stored in different queues. Then, by switching the target queue on the basis of unique rules according to the type of processing contents, it is made possible to complete processes that should surely be executed, in accordance with absolute criteria.

In addition, by determining queue switching rules while taking into consideration the causal relation between the process frequency of access requests from the host unit 12 and the frequency at which management processes become necessary, their balance is optimized, and estimation of required time and bandwidth is facilitated. Hereinafter, process requests for management processes and access requests from the host unit 12 are collectively called "commands" in some cases.

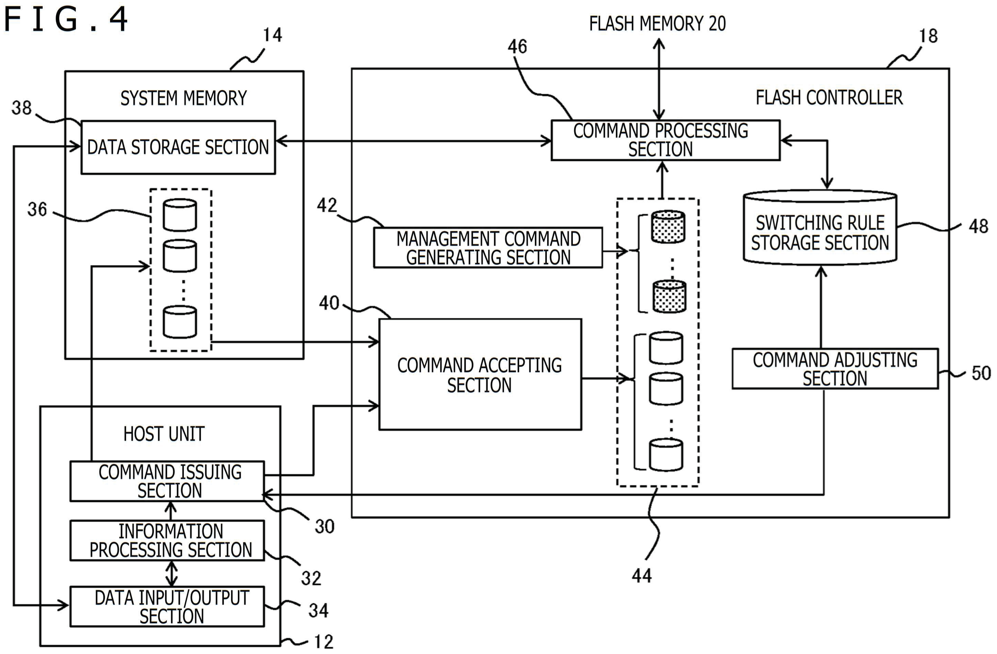

FIG. 4 depicts the configuration of functional blocks of the information processing device in the present embodiment. The individual functions depicted in FIG. 4 can be implemented hardware-wise by using circuitry configuration depicted in FIG. 1, and implemented software-wise by using a program that is retain in an internal memory. Accordingly, those skilled in the art understand that the individual functions can be implemented in various forms by only hardware, by only software, or by a combination of these, and the forms of the individual functions are not limited to any one of them.

The host unit 12 includes a command issuing section 30 that issues commands for accessing the flash memory 20, an information processing section 32 that processes application programs and the like, and a data input/output section 34 that inputs/outputs data to be read from or written into the flash memory 20. The system memory 14 includes a plurality of queues 36 that store the commands issued from the host unit 12, and a data storage section 38 that stores data to be read from or written into the flash memory 20.

The flash controller 18 includes a command accepting section 40 that acquires, from the host unit 12, a notification that a command has been issued, a management command generating section 42 that generates commands for management of the flash memory 20, a plurality of queues 44 that store individual commands including the commands for management, a command processing section 46 that sequentially processes the commands stored in the queues 44, a switching rule storage section 48 that stores rules for switching the processing-target queue, and a command adjusting section 50 that adjusts the ratio of management process implementation by using a predetermined technique.

The information processing section 32 of the host unit 12 processes a program such as an application selected by a user. When it becomes necessary to read data stored in the flash memory 20 or write data into the flash memory 20 in the course of this process, the information processing section 32 gives the command issuing section 30 a notification to that effect. In response to this, the command issuing section 30 issues a read or write command designating the access-destination logical address.

More specifically, the command issuing section 30 stores a command in any of the plurality of queues 36 of the system memory 14 and gives the flash controller 18 a notification to that effect. At this time, the command issuing section 30 classifies the command on the basis of the level of urgency in addition to access contents such as whether the command is a read request or a write request, and stores the command in a queue corresponding to the classification result. Because of this, command classification rules based on access contents, time limit, the size of data to be accessed, and the like and address information of corresponding queues are set in advance in a program to be processed by the information processing section 32 or the like.

In a case where the command is a write request, the data input/output section 34 acquires data that should be written, from the information processing section 32, and stores the data in the data storage section 38 of the system memory 14. In addition, the data input/output section 34 reads, from the data storage section 38, data that the flash controller 18 has read from the flash memory 20 in response to a read request, and supplies the data to the information processing section 32.

The command accepting section 40 of the flash controller 18 accepts, from the host unit 12, a notification that a command has been issued, reads the command from a relevant queue of the system memory 14, and stores the command in a corresponding one of the plurality of queues 44 retained therein. Here, the queues 44 retained by the flash controller 18 include a plurality of queues having the same configuration as the plurality of queues 36 in the system memory 14. Alternatively, the queues 36 in the system memory 14 may be able to be referred to as part of the queues 44.

When management processes such as the abovementioned scan read, garbage collection, data copy for read disturb avoidance, and data copy from an SLC to a TLC become necessary, the management command generating section 42 issues commands requesting those processes. More specifically, the management command generating section 42 determines a timing at which a command for a management process should be issued, by monitoring the elapsed time or monitoring the situation of data write into or read from the flash memory 20. Determination rules are set in advance for each of management process contents.

Then, the management command generating section 42 stores a command designating the processing contents, the data read-destination address, the write-destination address, a block in which data should be erased, and the like, in a queue that is one of queues for management processes included in the queues 44 and that corresponds to the processing contents. Note that, in FIG. 4, of the queues 44, queues that store commands issued by the host unit 12 are represented with white fill, and queues that store commands issued by the management command generating section 42 are represented with hatching, thereby distinguishing them.

The command processing section 46 sequentially processes commands stored in the queues 44. At this time, the command processing section 46 processes commands stored in each queue, in the order in which the commands are stored. In addition, the command processing section 46 switches to the next processing-target queue in accordance with switching rules set for each queue. That is, there can be a case where commands stored in another queue are processed in an order different from the order of issuance. The queue switching rules are stored in advance in the switching rule storage section 48 and are referred to by the command processing section 46.

In a case where a command read from a queue is a write request, the command processing section 46 reads data that should be written, from the data storage section 38 of the system memory 14, and then writes the data in an area corresponding to a logical address included in the command. In a case where a command is a read request, the command processing section 46 stores, in the data storage section 38 of the system memory 14, data read from an area corresponding to a logical address included in the command.

In a case where a command is a scan read, the command processing section 46 implements a read process once or multiple times at varied read voltages, on some pages in a block designated by the command. When data has been able to be read at an error rate within the range of ECC correction capability, the read voltage used at that time is registered such that the read voltage can be used in subsequent read processes. This process may basically follow a procedure similar to that explained with reference to FIG. 3. In a case where a command is a command for data transfer inside the flash memory 20, the command processing section 46 copies data from a copy-source address included in the command to a copy-destination address. In addition, as necessary, the data in the copy-source block is erased.

The command adjusting section 50 adjusts the ratio of processes to be implemented, such that memory access is not disrupted due to incomplete management processes. For example, when the number of commands that are stored in the queues 44 and are for management processes has exceeded a predetermined threshold, the command adjusting section 50 temporarily changes at least any one of the queue switching rules stored in the switching rule storage section 48 or gives the host unit 12 a notification to that effect.

In the former case, the command adjusting section 50 increases the upper limit on the time limit or number of command processes, which is set as a rule for switching from a queue storing a command for a management process to the next queue, or reduces the upper limit on the number of command processes for other queues, for example. Thus, the ratio of management process implementation can be substantially increased. When the number of commands for management processes stored in the queues 44 has become equal to or smaller than the threshold described above, the command adjusting section 50 restores the queue switching rules to their original rules.

In a case where the command adjusting section 50 gives the host unit 12 a notification, the command issuing section 30 of the host unit 12 limits command issuance in response to the notification. For example, the command issuing section 30 temporarily stops the issuance of low-urgency commands or limits the issuance frequency to a value which equal to or smaller than a predetermined value. Also in this manner, the ratio of management process implementation is substantially increased. Note that the timing for changing queue switching rules or giving the host unit 12 a notification may be different from the timing described above.

For example, since the necessity for a process for avoiding scan read, garbage collection, and read disturb can be predicted on the basis of the elapsed time from the previous process, the elapsed time from data write, the memory access situation until then, and the like, measures against them can be taken in advance. For example, when the elapsed time since the last scan read has been performed has exceeded a predetermined threshold, the command adjusting section 50 determines that a scan read command will be issued soon. In addition, when the number of writable blocks has become equal to or smaller than a predetermined threshold, the command adjusting section 50 determines that a garbage collection command will be issued soon. The threshold used here is certainly a value greater than a threshold to be used when a garbage collection command is actually issued.

Alternatively, the command adjusting section 50 determines that a data copy command for read disturb avoidance will be issued soon, when a predetermined condition, such as the error rate of read data exceeding a threshold even if the read voltage is adjusted, is satisfied as a result of scan read. Then, by changing queue switching rules or giving the host unit 12 a notification at these timings, it becomes possible to perform adjustment in advance, thereby enabling reduction of the adjustment amount.

It may be made possible to gradually limit the command issuance by the host unit 12 by regularly notifying the host unit 12 of the number of writable blocks or the number of times of read processes on the same block. In addition, handling by changing queue switching rules and notifying the host unit 12 may be performed independently or may be performed simultaneously. By such an adjustment process, it is possible to maintain an appropriate balance between processes for access requests from the host unit 12 and management processes required for the flash memory 20 itself and to ensure short latency for processes for highly-urgent commands.

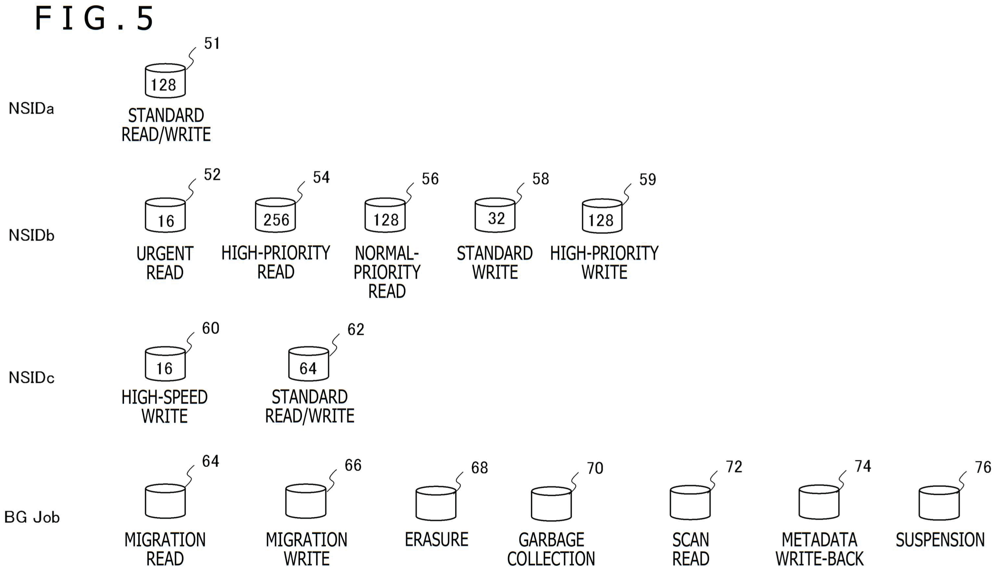

FIG. 5 depicts a configuration example of the queues 44. Here, each cylinder schematically represents a queue, and immediately below each cylinder, the type of a command stored in the queue is indicated. The side surface of each cylinder indicates an example of the upper limit on the number of command entries. The flash memory 20 is divided into logical partitions having different NSs (Name Spaces) and is accessed exclusively. A queue is also provided for each of the partitions. FIG. 5 depicts, sequentially from top, queues that are provided for name spaces ("NSIDa," "NSIDb," and "NSIDc") with identification reference signs a, b, and c. FIG. 5 also depicts, in the bottom portion, queues that are provided for "BG Job" (Background Job) representing management processes.

In this example, "NSIDa" is a partition accessed by a normal file system, and a queue 51 in which standard read commands and write commands are mixedly present is provided. For example, it is assumed that the upper limit on the number of command entries in the queue 51 is 128. "NSIDb" is a partition for handling mainly read-only file archives. A queue 58 dedicated for write commands is used to write a file tentatively, and thereafter, queues 52, 54, and 56 dedicated for read commands are used to read data. As an example, it is assumed that the upper limits on the numbers of command entries in the queues 52, 54, 56, 58, and 59 are 16, 256, 128, 32, and 128, respectively.

Here, the queues dedicated for read commands include a plurality of queues according to their levels of urgency. In FIG. 5, three levels are defined as follows: the "urgent read" queue 52 with the highest urgency; the "high-priority read" queue 54 with the next highest urgency; and the "normal-priority read" queue 56 with the lowest urgency. Note that the number of levels is not intended to be limited to this. In addition, in the queues 58 and 59 dedicated for write commands, the queue 58 is a "standard write" queue whose priority is substantially the same as that of the queue 51 of "NSIDa," and the queue 59 is a "high-priority write" queue corresponding to high-speed write. In a case where there is available space in SLC write caches, similarly to read, processes for write commands stored in the "high-priority write" queue 59 are scheduled during a phase 1, a phase 4, and a phase 5 mentioned later.

"NSIDc" is a partition including SLCs and is provided with a "high-speed write" queue 60 dedicated for high-speed write commands and a queue 62 in which read commands and write commands are mixedly present. The latter is a standard queue whose priority is substantially the same as that of the queue 51 of "NSIDa." As an example, it is assumed that the upper limits on the numbers of command entries in the queues 60 and 62 are 16 and 64, respectively.

As "BG Job," a read command queue 64 in data copy (migration), a write command queue 66 in data copy, a data erasure command queue 68, a garbage collection command queue 70, a scan read command queue 72, a metadata write-back command queue 74, and a suspend command queue 76 are provided. In addition to these queues, there may be queues that store commands for managing the system, separately from management processes like the ones mentioned above that should be executed in the background during operational use, or there may be other queues.

As mentioned above, the command processing section 46 of the flash controller 18 sequentially processes stored commands while switching queues in accordance with rules stored in the switching rule storage section 48. More specifically, the command processing section 46 classifies the queues 51 to 76 into multiple types and allocates a processing period to each type in a cyclical manner. At the time point when the number of processes for commands has reached the upper limit or the time limit has expired during a period targeting processes for a certain type of queue, the transition to a period targeting processes for the next type of queue is made. It is made possible to independently set the upper-limit number of processes or the time limit for each type of queue. Hereinafter, a period allocated for each type of queue is called a "phase."

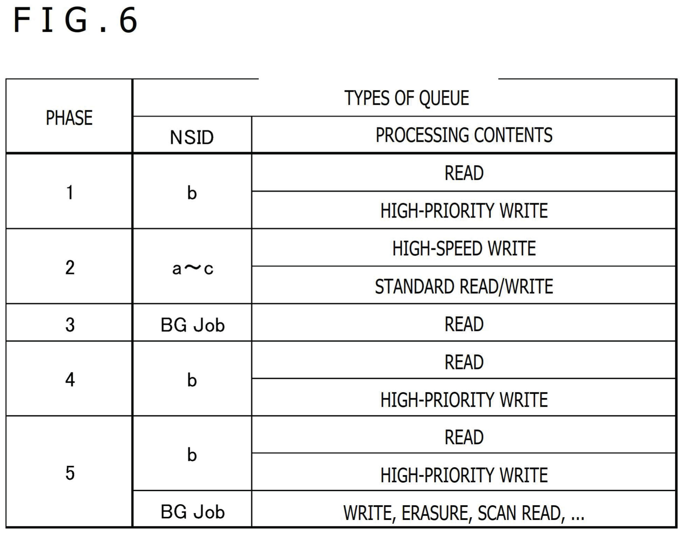

FIG. 6 depicts a setting example of types of queue processed during each phase. In this example, there are five periods, that is, the phase 1 to the phase 5, and the transition to the phases 1, 2, 3, 4, 5, 1, 2, ... is made in a cyclical manner. First, the phase 1 targets processes for read command queues and high-priority write command queues for NSIDb. In the example in FIG. 5, these correspond to four queues, that is, the queues 52, 54, 56, and 59.

In the read command queues 52, 54, and 56, queues including highly-urgent commands are given higher processing priority. In addition, after processes for a predetermined number of read commands have ended, high-priority write commands stored in the queue 59 are processed, and processes are performed in a loop in a manner like this. Note that the number of commands is counted by treating access to a predetermined size of data as one unit. The same also applies to the following explanation.

The phase 2 targets processes for high-speed write command queues for NSIDc, standard read/write command queues for NSIDa and NSIDc, and standard write command queues for NSIDb. In the example in FIG. 5, these correspond to the queues 60, 51, 62, and 58. When a command is stored in the high-speed write command queue 60 of these queues, the command is given priority, thereby achieving high-speed write into an SLC.

The phase 3 targets processes for the read command queue 64 in data copy which is included in the queues for BG Job, that is, for management processes. Commands stored in the queue 64 correspond to read processes for transferring data having been stored in the flash memory 20 to a different area, and portions for reading data in data copy from an SLC to a TLC, for example. Data having been read is temporarily stored in the SRAM 24 inside the flash controller 18, or the like.

Similarly to the phase 1, the phase 4 targets processes for read command queues and high-priority write command queues for NSIDb. By dividing processes for the same queue into two periods, a command issued immediately after the end of the earlier period can be processed promptly during the next period, and the maximum latency can be reduced. Similarly to the phases 1 and 4, the phase 5 targets processes for read command queues and high-priority write command queues for NSIDb and also targets processes for queues which are included in the queues for BG Job, that is, for management processes, except the read command queue which is the processing target in the phase 3. In the example in FIG. 5, these correspond to six queues, that is, the queues 66, 68, 70, 72, 74, and 76.

For example, in a case where the write command queue 66 for data copy is the processing target, data which has been read in the phase 3 is written into a transition-destination area in the flash memory 20, such as a TLC. In addition, in a case where the data erasure command queue 68 is the processing target, data in an area that has been invalidated due to the transfer of the data which has been read in the phase 3 is erased.

In a case where display images are rendered at a predetermined frame rate by using data stored in NSIDb, there can be a case where latency in the data read results in screen freezes, dropped frames, and so on. Since any commands stored in queues for management processes require a significant amount of time to complete the processes, the commands are divided into two levels of processes for the phase 3 and the phase 5, thereby preventing a process requiring real-timeness, such as display image rendering, from being hindered.

In addition, as compared to data read from or write into an SLC, write into and data erasure from a TLC require several times more time. Write into and erasure from a NAND flash memory are typically divided into a plurality of steps in order to reduce variations among memory cells, and are implemented while the state is being checked. In recent NAND flash memories, it is often possible to suspend erasure and write steps, perform a read process and a write process into an SLC, and then resume the erasure and write processes again. Erasure suspension and resumption are called erase suspend/resume, and write suspension and resumption are called program suspend/resume.

By using this mechanism, even in a case where an erasure process requires 5 to 20 msec and a TLC write process requires 1 to 3 msec, read commands and write commands into an SLC can be issued with a latency of 100 to 200 µsec. Accordingly, erasure processes and TLC write processes are grouped together as the phase 5, and a time limit is provided such that, even if a process is underway, the process can be suspended tentatively to transition to a command in another queue. Other than this, a management process may be suspended at the time point when a command is stored in a highly-urgent queue, for example, the "urgent read" queue 52 in FIG. 5. Thus, in a mode in which display images are rendered by using data read from NSIDb as mentioned above, the effect on the display images can be minimized.

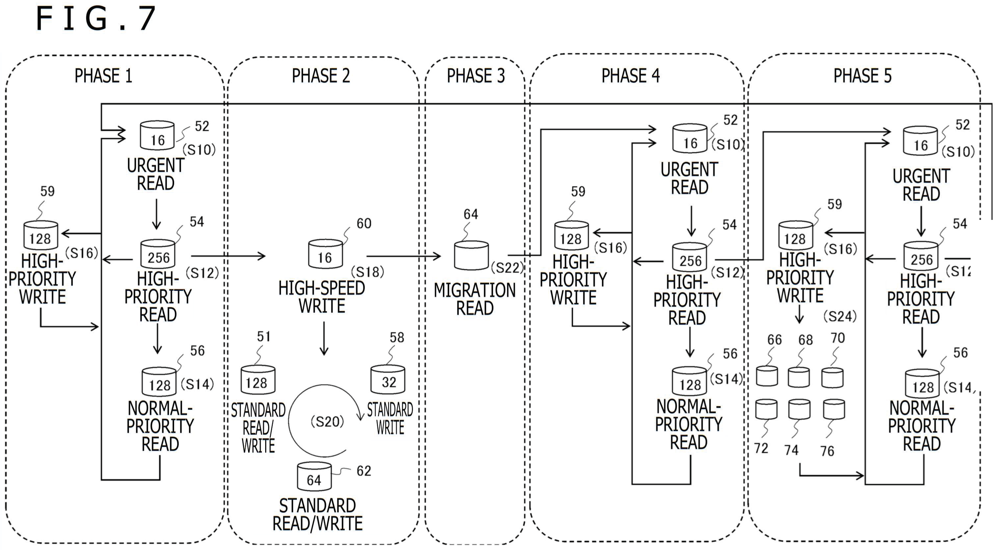

FIG. 7 illustrates an example of a procedure performed by the command processing section 46 to process commands stored in each queue while transitioning between phases. As mentioned above, the command processing section 46 switches between queues and sequentially reads commands starting from ones that have been stored earliest in each queue, to perform corresponding memory access. In FIG. 7, the process is represented by using cylinders representing the target queues, and each queue corresponds to one depicted in FIG. 5. Note that it is assumed that, in a case where no commands are stored in a queue, the process transitions to the next queue.

First, in the phase 1, the command processing section 46 performs read and write for NSIDb. In the example in FIG. 7, stored commands are processed in the order of the urgent read command queue 52, the high-priority read command queue 54, and the normal-priority read command queue 56. At this time, the command processing section 46 continues processes for commands stored in the urgent read command queue 52, until the upper limit on the number of processes which is preset for the queue 52 is reached (S10). Here, for example, the upper limit on the number of processes for commands is two or the like for each channel.

When the number of processes for commands stored in the urgent read command queue 52 has reached the upper limit or when there are no more commands that should be processed, the command processing section 46 next processes commands stored in the high-priority read command queue 54 (S12). In a case where there is a remaining command in the urgent read command queue 52 or a new command is stored in the urgent read command queue 52 on during this period, upon completing the currently-processed command, the command processing section 46 transitions the process to the command stored in the urgent read command queue 52 (S10).

Also in this case, when the number of processes for commands stored in the urgent read command queue 52 has reached the upper limit or when there are no more commands that should be processed, the command processing section 46 returns the process to commands stored in the high-priority read command queue 54 (S12). After completing the processes for the commands stored in the high-priority read command queue 54, the command processing section 46 next processes commands stored in the normal-priority read command queue 56 (S14). In a case where there is a remaining command in the urgent read command queue 52 or a new command is stored in the urgent read command queue 52 on during this period, upon completing the currently-processed command, the command processing section 46 transitions the process to the command stored in the urgent read command queue 52 (S10).

Also in this case, when the number of processes for commands stored in the urgent read command queue 52 has reached the upper limit or when there are no more commands that should be processed, the command processing section 46 returns the process in the order of the high-priority read command queue 54 and the normal-priority read command queue 56 (S12, S14). After processing a predetermined number of read commands in this cycle, the command processing section 46 processes commands stored in the high-priority write command queue 59 (S16). For example, the number of processes for read commands after which the process transitions to write commands here is 32 or the like for each channel.

When all the commands stored in the high-priority write command queue 59 have been processed or the upper limit on the number of command processes which is preset for the queue 59 has been reached, the command processing section 46 returns to the processes for read commands in S10, S12, and S14. The command processing section 46 repeats the processing procedure described above until a preset condition for transition from the phase 1 to the phase 2 is satisfied, and transitions the process to the phase 2 when the transition condition has been satisfied. Here, for example, the transition condition is that the total number of commands processed has reached a set upper limit, or that a time limit given to the phase 1 has expired.

By such a processing procedure, highly-urgent queues can be monitored more frequently for command storage and can be prioritized for processing, and the time from command issuance until processing completion can be minimized. In addition, processes for relatively-low-urgency commands can be deferred by setting an upper limit on the number of processes as a constraint condition, and transition to another phase is tolerated, thereby enabling control of required time and bandwidth in the overall phase.

In the subsequent phase 2, the command processing section 46 performs data read and write for NSIDa to NSIDc. The command processing section 46 first processes commands stored in the high-speed write command queue 60 for NSIDc (S18). When all the commands stored in the queue 60 have been processed, the command processing section 46 sequentially processes, in a round-robin manner, commands stored in the standard read/write command queue 51 for NSIDa, the standard write command queue 58 for NSIDb, and the standard read/write command queue 62 for NSIDc (S20).

The command processing section 46 performs the processes in S18 and S20 until a preset condition for transition from the phase 2 to the phase 3 is satisfied, and transitions the process to the phase 3 when the transition condition has been satisfied. Here, for example, the transition condition is completion of processes for four write commands, completion of processes for 16 read commands, completion of processes for two write commands and eight read commands, completion of processes for one write command and 12 read commands, or completion of processes for three write commands and four read commands. Since write for NSIDa and NSIDb is performed via SLCs used as write caches, latency can be kept constant by individually setting the number of processes for write commands for SLCs and the number of processes for read commands for SLCs or TLCs.

In the subsequent phase 3, the command processing section 46 performs read for data copy in management processes. That is, the command processing section 46 processes commands stored in the read command queue 64 for BG Job (S22). For example, the command processing section 46 processes a predetermined number of commands and stores data designated by each command, from the flash memory 20 to the SRAM 24 inside the flash controller 18. After this ends, the command processing section 46 transitions the process from the phase 3 to the phase 4.

In the subsequent phase 4, the command processing section 46 performs read and write for NSIDb again. Since this process is performed in a procedure similar to that explained regarding the phase 1, explanation thereof is omitted. The condition for transition from the phase 4 to the phase 5 may also be similar to the condition for transition from the phase 1 to the phase 2. In the subsequent phase 5, the command processing section 46 implements read and write for NSIDb and implements write processes, data erasure, garbage collection, scan read, and the like in management processes.

As mentioned above, by dividing management processes into the phase 3 and the phase 5, latency of read for NSIDb can be reduced. Although the phase 5 targets processes that require several times more time than write into SLCs, such as write into TLCs or block data erasure, these processes are suspended in accordance with a suspend command after the elapse of a predetermined length of time, and read from SLCs or TLCs and write into SLCs are performed, thereby enabling reduction of latency of processes that require faster execution.

In the phase 5, the command processing section 46 first performs read and write for NSIDb. Since this process is basically performed in a procedure similar to that explained regarding the phase 1, explanation thereof is omitted. Note that, when all the commands stored in the high-priority write command queue 59 have been processed or the upper limit on the number of command processes which is preset for the queue 59 has been reached in S16, the command processing section 46 processes commands targeting the write command queue 66, the data erasure command queue 68, the garbage collection command queue 70, the scan read command queue 72, the metadata write-back command queue 74, and the suspend command queue 76 for BG Job (S24).

Of these commands, if there is a command for which a process has been suspended before, the command processing section 46 resumes the process from the point of suspension. This process is actually implemented by a program resume or erasure resume command. If there are no suspended commands, the command processing section 46 processes as appropriate commands stored in the queues 66, 68, 70, 72, 74, and 76 for BG Job, at designated timings.

When the command processing section 46 completes all the command processes or when a preset time limit expires after the command processing section 46 continues management processes until the expiration, the command processing section 46 returns the process to the cycle of read and write for NSIDb. The suspension of a process as a result of the expiration of time is implemented by a process for a command in the suspend command queue 76. It is assumed here that, for example, the time limit for returning the process to the cycle of read and write for NSIDb is 700 µsec or the like.

The command processing section 46 repeats the processing procedure described above until a preset condition for transition from the phase 5 to the phase 1 is satisfied, and transitions the process to the phase 1 when the transition condition has been satisfied. Here, for example, the transition condition is completion of a single unit of any of processes such as data write, data erasure, or scan read in management processes or expiration of a time limit given to the phase 5. It is assumed here that the time limit is 10 msec or the like.

In the depicted processing procedure, by setting the upper-limit number of processes or time limit of commands in each phase at an appropriate balance while taking into consideration the causal relation between the number of commands issued from the host unit 12 and the occurrence of management processes, it is possible to smoothly process all the management processes without disruption. In addition, by appropriately switching the processing-target queue in each phase according to the processing contents or priority as mentioned above, the time from the issuance of each command until the processing completion of the command can be controlled.

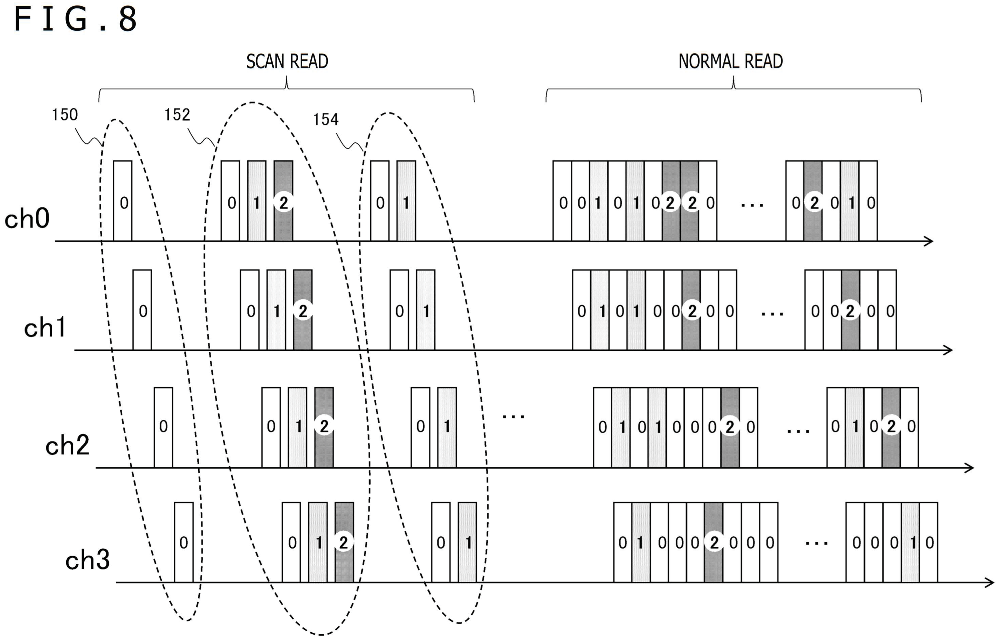

Next, a process of implementing scan read, which is one of the management processes, and optimizing the read voltage to be used at the time of data read is explained. FIG. 8 illustrates an example of the state of progress of data read processes during a period in which scan read is being implemented and the other period. The horizontal direction in FIG. 8 represents the time axis, and the data read time of one unit of the four channels "ch0" to "ch3" of the flash memory 20 is represented by a rectangle. The numerals 0, 1, and 2 depicted inside individual rectangles are read voltage identification numbers, and individual read processes are implemented at the actual read voltages associated in advance with the identification numbers.

Conventionally, technologies for scanning an SSD and detecting defects are performed manually or automatically. At this time, the flash controller 18 performs scan for each block which is a unit of data erasure, and measures the error rate. Then, when the error rate has approached the limit of the range of ECC correction capability, block copy in which data written in the block is re-written in another block is implemented.

Scan read according to the present embodiment is a process in which a block is treated as the smallest unit, partial data of the block is selectively read, and another read voltage is tested in a case where the error rate exceeds a threshold corresponding to the ECC tolerance amount, thereby acquiring a read voltage at which data falling within the ECC tolerance amount is read in the end. Each of broken-line ellipses in the scan read period in FIG. 8 represents the read time of a target block group of a single read (scan). That is, each of ellipses 150, 152, and 154 surrounds the read time of block groups scanned first, second, or third.

Write for TLCs is performed by using SLCs as caches and copying data from the SLCs, allowing the write to be executed simultaneously across all channels. Since, as mentioned above, the read voltage is determined according to the temperature at the time of data write, the temperature at the time of data read, and the elapsed time and temperature from write, it is assumed that the optimum read voltage becomes substantially the same for corresponding blocks across individual channels into which data has been written during the same period.

In view of this, efficient control becomes possible by collectively treating a block group for which data write has been performed during the same period across a plurality of channels (or all channels), as the scan target, and determining the optimum read voltage for that unit as depicted in FIG. 8. Similarly to the example depicted in FIG. 3, assuming that the read voltage identification number in the initial setting is "0," since read for the first block group represented by the ellipse 150 succeeds with its settings and the error rate is equal to or lower than the threshold in the example depicted in FIG. 8, the read process ends at the time point. In this case, the setting of the read voltage remains set to the identification number "0."

In read for the second block group indicated by the ellipse 152, read at the read voltage with the identification number "0" has failed, or the error rate has exceeded a threshold even if the read has succeeded, and accordingly, read is retried at the read voltage with the identification number "1." However, also in this case, since the read has failed or the error rate has exceeded the threshold even if the read has succeeded, the second retry is implemented at the read voltage with the identification number "2." Since the read has succeeded and the error rate is thus equal to or lower than the threshold, the read process for the block group is ended at the time point, and the setting of the read voltage is updated with the value of the identification number "2."

Also in read for the third block group indicated by the ellipse 154, read at the read voltage with the identification number "0" has failed, or the error rate has exceeded a threshold even if the read has succeeded, and accordingly, read is retried at the read voltage with the identification number "1." Since the read for the block group at the read voltage has succeeded and the error rate is equal to or lower than the threshold, the scan process is ended at the time point, and the setting of the read voltage is updated with the value of the identification number "1."

By performing such a scan read process regularly during a management process period, the read voltage can be kept at a state close to the optimum value. At the time of normal data read depicted on the right side of FIG. 8, random pages in each block group are treated as the read targets. A read voltage acquired as a result of scan read is associated with a block group in advance, and as depicted in FIG. 8, the read voltage is switched as appropriate depending on a block to be read. Thus, the likelihood of being able to read normal data in the first read process increases. Even if a retry becomes necessary, the probability that read succeeds with a small number of times of tries increases by adjusting the read voltage with the use of a read voltage obtained as a result of scan read, as a reference voltage.

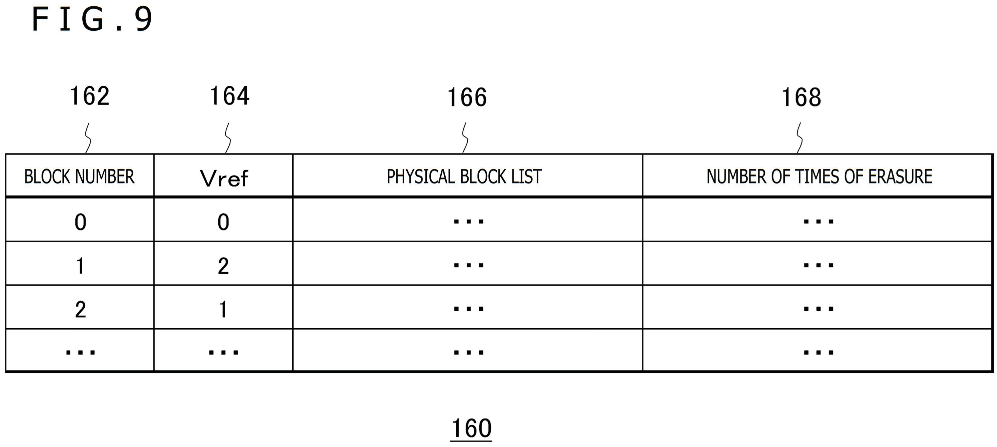

FIG. 9 illustrates an example of the data structure of a block management table to be referred to by the flash controller 18. A block management table 160 is stored in the DRAM 132 or the like and has a structure in which a block number 162, a read voltage (Vref) 164, a physical block list 166, and the number of times of erasure 168 are associated with each other. Note that the data structure is not limited to the one depicted. In addition, each piece of data may be associated with another table.

"0," "1," "2," ... included in the block number 162 are numbers identifying block groups scanned first, second, third, ... in FIG. 8 and may further be associated with LBAs. The physical block list 166 stores a list of the physical addresses of blocks included in each block group. For example, the flash controller 18 translates, into a physical address, an access-target LBA included in a command issued by the host unit 12, by referring to the physical block list 166 or the like.

In addition, each time data in a block group is erased, the flash controller 18 causes the number of times to be reflected in the number of times of erasure 168 and performs wear levelling to distribute erasure counts to all the block groups. In the present embodiment, the field of the read voltage 164 is added in the block management table 160, and the latest optimum value of the read voltage obtained by scan read like the one depicted in FIG. 8 is associated with each block group. While the identification numbers "0," "1," "2," ... are depicted as the read voltage 164 in FIG. 9, the manner of labeling is not limited to this.

The flash controller 18 refers to the block management table 160 and acquires a target physical address of a normal data read request. Simultaneously, the flash controller 18 refers to the field of the read voltage 164 and acquires an optimum read voltage. Then, the flash controller 18 issues a read voltage change command designating the voltage (or identification number), in association with a read command. Thus, the command processing section 46 can read data at a read voltage optimum for each read-destination block.

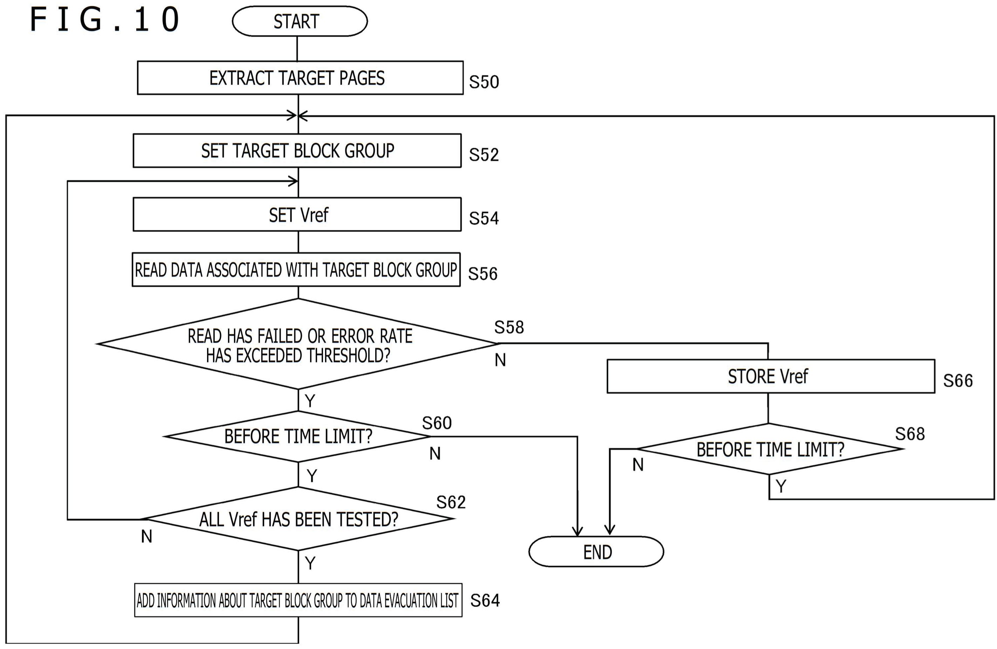

FIG. 10 is a flowchart depicting a processing procedure performed by the flash controller 18 to perform scan read and determine an optimum read voltage. This process is implemented by the management command generating section 42 issuing scan read commands at predetermined intervals and the command processing section 46 processing the scan read commands during a management process period. First, the management command generating section 42 extracts read-target pages in each block group and associates the pages with the block group in advance (S50).

Read-target pages are selected randomly for each block on the basis of a worst page list stored in advance in the DRAM 132 or the like. The worst page list is a list representing results of extraction of pages with error rates that exceed a threshold from each block on the basis of preliminary NAND evaluation. Since pages with high error rates are fixed to some extent due to physical factors related to memory cells, by narrowing down the scan-read target to any of the pages, it becomes possible to try data read and measure error rates by assuming the worst case.

For example, assuming that channels are "0" to "3" and that LUNs (Logical Unit Numbers) are "0" and "1," the management command generating section 42 determines read-target pages in each of eight areas, that is, (CH:LUN) = (0:0, 0:1, 1:0, 1:1, 2:0, 2:1, 3:0. 3:1), for each block group. There may be one read-target page per block, or there may be a plurality of read-target pages per block. In addition, suitably, read targets are dispersed by reading different pages across different block groups.

Next, the command processing section 46 sets one read-target block group (S52) and sets a provisional read voltage Vref (S54). As depicted in FIG. 8, the first read uses a read voltage, such as the initial setting value, that has been used until then. Then, the command processing section 46 reads, at the read voltage set in S54, data of pages associated with the target block group set in S52 (S56).

In a case where read has failed or the error rate of read data has exceeded a threshold (Y in S58), as long as the time limit given to management processes of the phase 5 has not been exceeded and there are untried read voltages, the command processing section 46 sets the read voltages and retries data read (Y in S60, N in S62, S54, S56). The loop from S54 to S62 is repeated, and when the time limit given to management processes has been exceeded (N in S60), the command processing section 46 end the scan read process.

On the other hand, in a case where read has failed or the error rate of read data has exceeded the threshold even after all the read voltages have been tested (Y in S62), the command processing section 46 adds information about the read-target block group to a data evacuation list (S64). Thus, it is made possible to copy data of the entire block group to a different area at a subsequent management process timing such that the data can be reproduced in the area.

In a case where, as a result of one retry or a plurality of retries, data read succeeds and the error rate is equal to or lower than the threshold (N in S58), the command processing section 46 stores the read voltage used at that time in a field of the read voltage 164 in the block management table 160 in association with the target block group (S66). Thus, thereafter, data read is performed at the optimum read voltage. In a case where the time limit given to management processes of the phase 5 has been exceeded at this stage (N in S68), the command processing section 46 ends the scan read process.

On the other hand, in a case where the time limit has not been exceeded (Y in S68) or where the information about the block group has been added to the evacuation list in S64, the command processing section 46 sets one next read-target block group (S52) and repeats the processes from S54 to S68. Thus, scan read is performed on a plurality of block groups within the time limit given to management processes, and an optimum read voltage is registered.

Since scan read is error rate measurement, there is a likelihood that the overhead becomes greater than that in normal data read processes. However, since the time required for a single scan read is equal to or shorter than 200 µsec, it is possible to scan approximately three or four block groups within the time limit of 700 µsec given to management processes. Since management processes are scheduled repeatedly if there are no other read/write traffic, scan of the entire flash memory 20 having 300 to 400 blocks per plane in the idle state can be completed within 100 msec.

Variations in the optimum read voltage resulting from leakage of electric charge due to temperature or elapsed time surface over a span of several hours to several days even under high-temperature operation. On the other hand, variations in the optimum read voltage resulting from temperature differences between the time of write and the time of read or read disturb surface in as little as several tens of seconds. Since the temporal scale of variations in the read voltage variously differs depending on causes of the variations in this manner, a plurality of sets of the area and processing frequency of scan-read target blocks, each corresponding to one of the causes, may be prepared.

For example, considering the case of electric charge leak and the case of read disturb, the flash controller 18 creates a list of block groups covering the entire flash memory 20 in the former case, and creates a list including block groups that have been accessed most recently in the latter case. Then, scan read is implemented for the block groups covering the entire flash memory 20, at long intervals such as once per hour, and scan read is implemented for the block groups having been accessed most recently, at short intervals such as once per minute.

In a case where the latter block group targets 30 to 40 blocks, the time required for scan read is approximately 10 msec, and the overhead is sufficiently small. In addition, since the intervals are sufficiently long, it is possible to perform control to issue scan read commands only during a period in which other commands need not be processed, that is, only in a state where queues are empty.

According to the present embodiment mentioned thus far, as a management process on the NAND flash memory, scan read is implemented regularly, and the optimum value of the read voltage is determined in advance. Thus, in read of data required for information processing, the likelihood of read failures or the occurrence of errors at a rate exceeding the range of ECC correction capability, which would lead to the occurrence of read retries and the occurrence of non-negligible latency, can be lowered.

Scan read is implemented in the unit of block groups for which write is performed during the same period, on pages whose error rates are high in each block. In addition, the scale of scan-target block groups and the scan frequency are varied according to the cause of the occurrence of variation in the read voltage. Thus, the optimum value of the read voltage can be determined efficiently.

Further, scan read commands, commands related to other management processes, commands related to read or write of data required for information processing, and the like are classified as appropriate and stored in different queues. Then, in accordance with rules set for each queue or phase settings, the target queue is switched, and commands are read and processed. Thus, processes can be switched at timings optimum for characteristics, and, for example, it is possible to avoid a situation where processes for highly-urgency access requests from the host unit are delayed due to scan read. As a result, memory access latency can be minimized, and information processing is allowed to progress stably with high throughput.

The present invention has been explained thus far on the basis of the embodiment thereof. The embodiment illustrates an example, and those skilled in the art understand that various modification examples are possible in terms of combinations of individual constituent elements and individual processing processes of the embodiment and that such modification examples are also within the scope of the present invention.

### [Industrial Applicability]

As described above, the present invention can be used for an information processing device such as a game device, a personal computer, and a mobile terminal.

### [Reference Signs List]

10: Information processing device
12: Host unit
14: System memory
18: Flash controller
20: Flash memory
22: Host controller
24: SRAM
28: NAND controller
30: Command issuing section
32: Information processing section
34: Data input/output section
36: Queue
40: Command accepting section
42: Management command generating section
44: Queue
46: Command processing section
48: Switching rule storage section
50: Command adjusting section
132: DRAM

## Claims

1. An information processing device comprising:
one or more processors having hardware, wherein
the one or more processors
perform data read from a memory at predetermined intervals,
determine and record a read voltage on a basis of a result of the data read, and
read data to be used for information processing, at the recorded read voltage.

2. The information processing device according to claim 1, wherein the one or more processors determine the read voltage for each set of a plurality of blocks in a flash memory.

3. The information processing device according to claim 1, wherein the one or more processors determine the read voltage for each set of a plurality of blocks for which data write has been performed during a same period across all channels of a flash memory.

4. The information processing device according to claim 2 or 3, wherein the one or more processors select a page with an error rate that exceeds a threshold, in each of the plurality of blocks, and performs the data read.

5. The information processing device according to claim 2 or 3, wherein the one or more processors perform the data read for block groups selected in accordance with different rules, at different intervals.

6. The information processing device according to claim 5, wherein the one or more processors perform the data read for a block group covering the memory and the data read for a block group having most recently been accessed, in such a manner that the latter data read is performed at shorter intervals than the former data read.

7. The information processing device according to any one of claims 1 to 3, wherein the one or more processors try the data read at varied read voltages and determine a read voltage at which data with an error rate equal to or lower than a threshold has been read.

8. The information processing device according to any one of claims 1 to 3, wherein the one or more processors end the data read at a time point when a predetermined time limit has expired.

9. An information processing device comprising:
one or more processors having hardware; and
a flash memory that stores data to be used by the one or more processors, wherein
the one or more processors
perform data read from the flash memory at predetermined intervals,
determine and record a read voltage on a basis of a result of the data read, and
read data to be used for information processing, at the recorded read voltage.

10. A memory management method comprising:
performing data read from a memory at predetermined intervals;
determining and recording a read voltage on a basis of a result of the data read; and
reading data to be used for information processing, at the recorded read voltage.

11. A recording medium having recorded thereon a program for causing a computer to implement:
a function of performing data read from a memory at predetermined intervals;
a function of determining and recording a read voltage on a basis of a result of the data read; and
a function of reading data to be used for information processing, at the recorded read voltage.
